# EUROPÄISCHE PATENTSCHRIFT

(11) **EP 2 480 720 B1**
(45) Veröffentlichungstag und Bekanntmachung des Hinweises auf die Patenterteilung: **08.01.2014**
(21) Anmeldenummer: 10740214.1
(22) Anmeldetag: 03.08.2010
(51) Int. Cl.: D21H 23/34, D21H 25/08, D21H 25/12, B41F 9/10, D21G 3/00, D21H 25/10

(54) **KLINGENBESCHICHTUNG**
BLADE COATING
COUCHAGE À LA LAME

(30) Priorität: 23.09.2009 DE 102009029698
(43) Veröffentlichungstag der Anmeldung: 01.08.2012
(73) Patentinhaber: Voith Patent GmbH, 89522 Heidenheim (DE)
(72) Erfinder: BISCHOF, Hubert, A-8680 Mürzzuschlag (AT); BERENDES, Antje, 88368 Bergatreute (DE); MAYR, Wolfgang Peter, A-1120 Wien (AT); ETSCHMAIER, Alexander, A-8692 Neuberg (AT); GAMSJÄGER, Norbert, A-2721 Bad Fischau (AT)
(86) Internationale Anmeldenummer: PCT/EP2010/061262
(87) Internationale Veröffentlichungsnummer: WO 2011/035968

(56) Entgegenhaltungen:
- WO-A1-00/00296
- WO-A1-2007/003332
- FR-A1- 2 748 759
- FR-A1- 2 770 234

## Beschreibung

Die Erfindung betrifft Rakel für Maschinen zur Papierherstellung und bezieht sich im Besonderen auf die Ausbildung von Rakel zur Verwendung beim Streichen einer Papierbahn.

In der Regel weist die im Papierherstellungsprozess produzierte Faservliesbahn, die sogenannte Rohpapierbahn, noch nicht die für die jeweils zu produzierende Papiersorte erforderliche Oberflächeneigenschaften auf und muss entsprechend bearbeitet werden.

Zum Glätten der Papierbahnoberfläche wird auf diese eine meist pastenförmige Strichlage aus Pigmenten, Bindemitteln und Hilfsstoffen aufgestrichen. Das Streichen der Papierbahn kann in einem gesonderten Arbeitsgang erfolgen, wird üblicherweise jedoch in den Papierherstellungsprozess durch Einbindung eines Streichwerks in die Papiermaschine integriert. Glatte Papieroberflächen werden mit dem Rakelstreichverfahren erzielt, bei dem die Streichfarbe zunächst im Überschuss auf das Papier aufgebracht und dann mit einer Rakelklinge abgerakelt wird. Durch die von der als Streichklinge bezeichneten Rakelklinge auf die Streichfarbe ausgeübten Druck werden die Vertiefungen der Papieroberfläche mit Strich aufgefüllt und eine gleichmäßige Oberfläche des gestrichenen Papiers erzielt.

Oberflächenstrukturen z.B. für Hygienepapiere werden nach dem Kreppverfahren erzeugt, wobei die Papierbahn über eine als Kreppmesser bezeichnete Rakel geführt wird.

Aufgrund des hohen Drucks mit dem die Rakelklinge bei den beiden Verfahren auf der Papierbahn aufliegt, in der Regel beträgt der Anpressdruck 150 N/m (Angabe in Anpresskraft bezogen auf die Länge der Rakelklinge) und mehr, werden hohe Anforderungen an die Verschleißfestigkeit der Rakelklinge gestellt.

Die für die Oberflächenbearbeitung der Papierbahn verwendeten Rakelklingen werden daher häufig aus einem hochfesten Stahl gefertigt.

Es ist bekannt die Oberfläche der Rakelklingen in den Bereichen, an denen die Klinge zur Auflage an der Papierbahn bzw. zum Kontakt mit dem Strichmaterial vorgesehen ist, mit einer Beschichtung zu versehen, die eine höhere Verschleißfestigkeit als das Grundmaterial der Rakelklinge aufweist. Solche Beschichtungen werden zumeist aus einem abriebfesten Material unter Verwendung von Metalloxiden oder Hartmetallen, bei denen ein Metallcarbid in einer Cobalt-, Nickel- oder Eisenmatrix eingebettet ist, gefertigt. Zum Aufbringen von physikalisch wie chemisch möglichst homogenen Beschichtungen werden vorzugsweise thermische Spritztechniken verwendet, wobei das Beschichtungsmaterial in mehreren Hüben aufgebracht wird. Jeder der Hübe bringt auf die Rakel bzw. auf die darauf bereits zuvor aufgebrachten Beschichtungslagen eine dünne Lage Beschichtungsmaterial auf. Das Auftragen der Beschichtung in mehreren dünnen Lagen stellt dabei sicher, dass sich die Komponenten des Beschichtungsmaterials beim Aufbau der Beschichtung nicht entmischen können. Aufgrund der chemischen sowie physikalischen Identität der einzelnen Lagen wird so eine homogene Beschichtung erzeugt.

Um das Entstehen von Rakelstreifen im Strich der Papierbahn bzw. auf der gekreppten Papierbahn zu verhindern, wird die Oberfläche der Rakelbeschichtung nach dem Aufbringen so glatt geschliffen, dass sie möglichst kleine Rauheitswerte aufweist. Bei bestimmten Kombinationen von Beschichtungsmaterial und für die Ausbildung des Rakelklingengrundkörpers verwendeten Materialien kann es erforderlich sein, zwischen Beschichtung und Rakelklingengrundkörper eine weitere Schicht anzuordnen, die eine bessere Haftung der Beschichtung auf dem Rakelklingengrundkörper ermöglicht.

In der internationalen Patentanmeldung WO 2006/134209 A1 ist eine Weiterentwicklung einer mit einer Haftschicht versehenen abriebfesten Rakelklingenbeschichtung vorgestellt. Die Beschichtung weist einen Mehrschichtaufbau auf, bei dem die zum Kontakt mit der Papierbahn vorgesehene Oberfläche der Beschichtung von einem harten Material, wie beispielsweise Wolframcarbid, Chromcarbid oder Titancarbid gebildet wird, während die an den Rakelgrundkörper angrenzende Seite der Beschichtung von einem Material mit guten Haftungseigenschaften auf dem Rakelgrundkörper gebildet wird. Als für diese Schicht geeignete Materialien sind Titanoxid und Aluminiumoxid angeführt. Die zwischen diesen beiden Außenschichten gelegenen Schichten weisen eine Mischung beider Schichtmaterialen auf, wobei der Anteil eines Schichtmaterials mit zunehmender Entfernung von der aus diesem Material aufgebauten Beschichtungsoberfläche abnimmt.

Beim Rakelstreichverfahren nutzt sich die Rakelklinge an den Rändern der Papierbahn stärker ab als dazwischen, da die äußeren Enden einer Rakelklinge in der Regel nicht mit einem Streichmaterial in Kontakt sind und daher von der rauen Oberfläche des die Rohpapierbahn bildenden Faservlieses schneller abgerieben werden, als der mit dem Streichmaterial in Berührung tretende Teil der Klinge. Um diesem Effekt entgegenzuwirken wird in der internationalen Patentanmeldung WO 98/28089 vorgeschlagen, an der Rakelklinge eine weitere Schicht anzuordnen, die zwischen dem Rakelklingengrundkörper und der eigentlichen Beschichtung angeordnet ist. Diese Hartmaterialzwischenschicht weist eine geringere Verschleißrate als die Nutzbeschichtung auf, und kann daher das Klingenprofil über einen längeren Zeitraum aufrechterhalten.

Ist eine Rakelklinge verschlissen, so muss sie ausgetauscht werden. Nach dem Austausch dauert es jedoch einige Zeit, bis die neue Rakelklinge "eingelaufen" ist, womit die Tatsache bezeichnet wird, dass obwohl die Rakelklingenbeschichtung genau auf die Geometrie der Papierbahnführung abgestimmt geschliffen wurde, in der Praxis noch kleinere Abweichungen beider Geometrien bestehen. In der Folge erzeugt die Rakelklinge nicht die geforderte Qualität der Papierbahnoberfläche. Die Zeit bis zum "Einlaufen" der Rakelklinge, das ist die Zeit, die benötigt wird, bis die Papieroberfläche die geforderte Qualität aufweist, kann bis zu einer Stunde betragen. Das während des Einlaufens produzierte Papier ist von minderer Qualität und muss unter Umständen entsorgt werden.

Es ist daher wünschenswert, eine Rakelklinge zur Oberflächenbehandlung von Faservliesbahnen wie z. B. Papierbahnen anzugeben, die kürzere Einlaufzeiten ermöglicht.

Gemäß einer Ausführungsform der Rakelklinge weist diese einen Grundkörper und eine an der Oberfläche des Grundkörpers angeordnete Beschichtung auf, wobei die Beschichtung zumindest den Teil der Oberfläche des Grundkörpers bedeckt, an dem die Rakelklinge zum Kontakt mit der Faservliesbahn vorgesehen ist und wobei die Beschichtung eine Porosität aufweist, die an der dem Grundkörper abgewandt angeordneten Oberfläche der Beschichtung größer ist, als an der an den Grundkörper angrenzenden Oberfläche der Beschichtung.

In diesem Zusammenhang wird darauf hingewiesen, dass die in dieser Beschreibung und den Ansprüchen zur Aufzählung von Merkmalen verwendeten Begriffe wie "umfassen", "aufweisen", "beinhalten", "enthalten" und "mit", sowie deren grammatikalische Abwandlungen, generell als nichtabschließende Aufzählung von Merkmalen, wie z.B. Verfahrensschritten, Einrichtungen, Bereichen, Größen und dergleichen aufzufassen sind, und in keiner Weise das Vorhandensein anderer oder zusätzlicher Merkmale oder Gruppierungen von anderen oder zusätzlichen Merkmalen ausschließen.

Eine Rakelklinge mit einer Beschichtung, deren Oberflächenbereich porös ausgebildet ist, weist im Gegensatz zu einer Rakelklinge mit einem im Wesentlichen nicht porös ausgebildeten Oberflächenbereich eine geringere Abriebfestigkeit auf und passt sich somit schneller an eine von der Rakelklingengeometrie abweichende Geometrie der über die Rakelklinge geführten Papierbahn an. Unter im Wesentlichen keine Poren aufweisend wird hierbei verstanden, dass die Porosität dem technisch möglichen Minimum entspricht.

Eine weitere Ausführungsform der Rakelklinge weist eine Beschichtung auf, deren Porosität von der ersten, an den Grundkörper angrenzenden Oberfläche zu der dieser gegenüber angeordneten Oberfläche hin zunimmt. Mit einem solchen Verlauf der Porosität über die Dicke der Beschichtung nimmt die Abriebfestigkeit der Klingenbeschichtung mit zunehmendem Abtrag zu, wodurch sich die Verschleißrate nach dem Einlaufprozess verringert und das eingelaufene Klingenprofil, das auch als Einlaufprofil bezeichnet wird, erhält.

Gemäß einer weiteren Ausführungsform weist die Beschichtung der Rakelklinge eine erste und eine zweite Schicht auf, wobei die erste Schicht an den Grundkörper angrenzt und im Wesentlichen keine Poren aufweist, während die auf der ersten Schicht angeordnete zweite Schicht eine vorgegebene Porosität aufweist. Hierdurch kann der porös ausgeführte Teil der Beschichtung auf die Dicke beschränkt werden, die zum Aufbau und Erhalt des Einlaufprofils erforderlich ist.

Bei einer weiteren Ausführungsform kann die Beschichtung der Rakelklinge eine oder mehrere weitere Schichten umfassen, die auf der dem Grundkörper abgewandten Seite der zweiten Schicht angeordnet sind. Die Porosität einer weiteren Schicht ist hierbei höher als die Porosität einer jeden zwischen dieser weiteren Schicht und der ersten Schicht angeordneten Schicht der Beschichtung. Eine entsprechend aufgebaute Beschichtung bietet große Freiheiten in der Gestaltung von Porositätsverläufen und damit die Möglichkeit der Anpassung eines Porositätsverlaufs an die jeweiligen Besonderheiten verschiedener Einlaufprozesse.

Gemäß einer weiteren Ausführungsform umfasst die erste Schicht der Beschichtung mehrere Lagen, wodurch ein chemisch wie physikalisch homogener Aufbau der ersten Schicht erreicht wird. In einer anderen Ausführungsform kann auch die zweite oder wenigstens eine der weiteren Schichten jeweils aus mehreren Lagen aufgebaut sein, wodurch eine bestimmte Porosität wie auch Materialzusammensetzung über eine bestimmte Schichtdicke aufrechterhalten werden kann.

Nach einer weiteren Ausführungsform beträgt, um eine hohe Standzeit der Beschichtung nach dem Einlaufen zu gewährleisten, die Dicke der ersten Schicht wenigstens die Hälfte der Dicke der Beschichtung.

Gemäß weiteren Ausführungsformen der Rakelklinge unterscheidet sich die Materialzusammensetzung der zweiten Schicht und/oder die einer weiteren Schicht der Beschichtung von der der ersten Schicht der Beschichtung. Hierdurch kann die Abriebfestigkeit der einzelnen Schichten zusätzlich variiert werden, um einerseits eine möglichst schnelle Anpassung des Klingenprofils an die Papierbahngeometrie zu erreichen und so die Einlaufphase zu verkürzen, und andererseits das in der Einlaufphase erhaltene Klingenprofil für die gesamte Lebensdauer der Klinge aufrechtzuerhalten. Beispielsweise kann die erste Schicht aus einem ersten Material gebildet sein, während die zweite und/oder eine oder mehrere der weiteren Schichten aus einem zweiten Material oder einer Mischung von erstem und zweitem Material gebildet sind.

Gemäß einer weiteren Ausführungsform enthält das erste Material ein metallartiges Carbid, wodurch eine Schicht mit einer hohen Härte erzielt wird. In einer weiteren Ausführungsform kann das zweite Material ein Metalloxid enthalten, wodurch ebenfalls eine ausreichend hohe Härte erzielt wird, die vorzugsweise aber geringer ist als die Härte einer mit dem ersten Material hergestellten Schicht.

Weitere Merkmale der Erfindung ergeben sich aus den nachfolgenden Beschreibungen von Ausführungsbeispielen in Verbindung mit den Ansprüchen sowie den Figuren. Die einzelnen Merkmale können bei einer Ausführungsform gemäß der Erfindung je für sich oder zu mehreren verwirklicht sein. Bei der nachfolgenden Erläuterung einiger Ausführungsbeispiele der Erfindung wird auf die beiliegenden Figuren Bezug genommen, von denen
Figur 1 einen schematischen Querschnitt durch eine beschichtete Rakelklinge zeigt,
Figur 2 den Bereich der Rakelklinge von Figur 1 nahe der Wate in einer vergrößerten Darstellung veranschaulicht,
Figur 3 ein Diagramm mit unterschiedlichen Verläufen der Porosität über die Dicke der Beschichtung zeigt, und
Figur 4 ein Diagramm zur Veranschaulichung des Verschleißverhaltens der Rakelklinge zeigt.

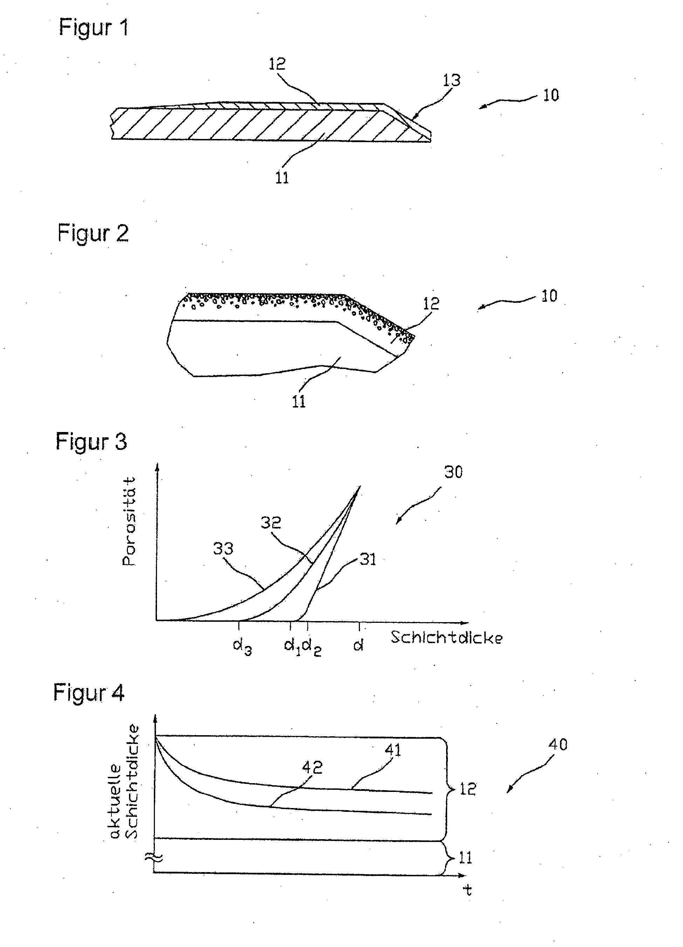

Die schematische Darstellung von Figur 1 zeigt einen Querschnitt durch den vorderen Bereich einer mit einer Beschichtung 12 versehenen Rakelklinge 10. Die Beschichtung 12 nimmt wenigstens den Teil der Rakelklinge 10 ein, der mit der Papierbahn bzw. einem darauf aufgebrachten Strichmaterial in Berührung kommt. Die Rakelklinge 10 weist einen Grundköper 11, der beispielsweise aus Stahl gebildet sein kann, sowie eine Beschichtung 12 auf. Die Rakelklinge 10 weist ferner eine Fase 13 auf, die allgemein als Wate bezeichnet wird. In der Regel überdeckt die Beschichtung 12 den Grundkörper 11 wie gezeigt auch im Bereich der Wate 13.

Die schematische Querschnittsdarstellung von Figur 2 zeigt einen detaillierteren Ausschnitt der Rakelklinge 10 von Figur 1 am Übergang zur Wate 13. Wie der Darstellung zu entnehmen weist die Beschichtung 12 Hohlräume auf, deren Dichte zur freien Oberfläche der Beschichtung hin zunimmt, d. h. in Richtung der dem Grundkörper 11 abgewandten Seite der Beschichtung 12. Mit anderen Worten ist die Porosität der Beschichtung 12 an deren Oberseite größer als an ihrer Unterseite, die an den Grundkörper angrenzt. Unter Porosität wird hierbei das Verhältnis von Hohlraumvolumen zu Gesamtvolumen einer Volumeneinheit der Beschichtung verstanden.

Der vom Beschichtungsmaterial eingenommene Anteil einer porösen Oberfläche ist geringer als deren gesamte Oberfläche. Entsprechend befindet sich bei einer porösen Oberfläche weniger Beschichtungsmaterial in Kontakt mit dem Faservlies oder dem Strichmaterial der Papierbahn, als bei einer nichtporösen Oberfläche. Bei gleicher Andruckkraft der Rakel ist die Verschleißrate der porösen Oberfläche in der Folge höher. Die Verschleißrate ist hierbei umso höher, je poröser die Oberfläche ist.

Um die zum Einlaufen der Klinge benötigte Zeit zu verkürzen, wird daher die Oberfläche der Beschichtung 12 porös ausgeführt, wobei sich die Poren vorzugsweise zumindest bis in eine Tiefe erstrecken, die während der Einlaufzeit beschliffen wird. Bei einer Ausführungsform weist die Beschichtung 12 zwei Schichten auf, wobei die erste, an den Grundkörper 11 angrenzende Schicht keine Poren aufweist bzw. die geringstmögliche Menge an Poren die sich mit einem zum Herstellen der Schicht verwendeten Prozess erzielen lässt. Durch eine solcherart gebildete Beschichtung wird sichergestellt, dass nach dem Einlaufvorgang eine abriebfeste Beschichtung vorliegt, die eine hohe Standzeit der Rakelklinge gewährleistet. Auf dieser ersten Schicht ist eine zweite Schicht angeordnet, deren Dicke wenigstens so groß ist, wie die beim Einlaufvorgang zu erwartende Klingenprofiländerung. Insbesondere weist die Dicke dieser zweiten Schicht einen Wert auf, der wenigstens der Differenz zwischen dem maximalen Abtrag und dem minimalen Abtrag der Schicht während des Einlaufvorgangs entspricht.

In einer weiteren Ausführungsform sind mehr als eine weitere Schicht auf der ersten Schicht angeordnet, wobei die Porosität einer jeden dieser weiteren Schichten mit zunehmender Entfernung von der ersten Schicht zunimmt, so dass an der dem Grundkörper 11 abgewandten Oberfläche der Beschichtung 12 die größte Porosität vorliegt. Alternativ kann die Porosität auch innerhalb einiger benachbarter Schichten konstant gehalten werden, wobei die Porositäten von Schichten nahe der freien Oberfläche der Beschichtung, d.h. nahe deren Oberseite, höher ist, als die von näher an der Unterseite der Beschichtung angeordneten Schichten.

Die Beschichtung 12 wird auf dem Grundkörper 11 vorzugsweise durch thermisches Spritzen über mehrere Hübe, beispielsweise zwischen 10 und 100 Hüben, aufgebracht. Jeder Hub erzeugt eine dünne Lage des Beschichtungsmaterials, wobei die erste Lage direkt auf die Oberfläche des Grundkörpers und weitere Lagen auf die jeweils zuvor aufgebrachte Lage aufgespritzt werden. Die physikalische Homogenität bzw. umgekehrt die Porosität der einzelnen Lagen kann über die Parameter des verwendeten Verfahrens eingestellt werden. Zum Beispiel kann bei dem mit dem Akronym HVOF (High Velocity Oxygen Fuel) bezeichneten Spritzverfahren die Porosität durch das Verhältnis von Brennstoff zu Sauerstoff und über die Förderrate des zur Schichtbildung verwendeten Pulvermaterials eingestellt werden. Durch Verändern der Parameter von Lage zu Lage kann die Porosität bis zur Oberseite der Beschichtung erhöht werden.

Eine erhöhte Verschleißrate der Beschichtung ist nur während der Einlaufphase gewünscht, die in der Regel nur einen äußerst geringen Bruchteil der gesamten Nutzzeit der Rakelklinge ausmacht. Am Ende des Einlaufprozesses weist die Oberfläche der Beschichtung 12 ein Profil auf, das optimal an die Geometrie der Faservliesbahn des Papiers am Rakelkontaktbereich angepasst ist. Ändert sich die Porosität der Beschichtung über deren Tiefe zu abrupt, so kann das Einlaufprofil in manchen Fällen vorübergehend verschliffen werden. Vorzugsweise verändert sich daher die Porosität zwischen den beiden Maximalwerten, d. h. der Porosität an der ursprünglichen Oberseite der Beschichtung und der Porosität an deren Unterseite stetig, d.h. ohne Sprünge.

Im Diagramm 30 von Figur 3 sind drei Beispiele für Porositätsverläufe innerhalb der Beschichtung 12 veranschaulicht. Bei dem Porositätsverlauf 31 ist die Porosität des Beschichtungsmaterials an der Unterseite der Beschichtung 12 gleich Null bzw. minimal, und nimmt ab einer Schichtdicke d₁ bis hin zu einer Schichtdicke d₂ nichtlinear, und ab der Schichtdicke d₂ bis zur Oberseite d der Beschichtung 12 hin linear zu. Ein entsprechender Porositätsverlauf 31 eignet sich insbesondere für Fälle, bei denen der maximale Abtrag der Beschichtung während der Einlaufphase gering ist.

Werden während der Einlaufphase tiefere Profile in die Oberfläche der Beschichtung eingeschliffen, so erstreckt sich die Porosität der Beschichtung 12 vorzugsweise über einen ausgedehnteren Bereich der Beschichtungsoberfläche, beispielsweise gemäß einem Porositätsverlauf wie er von der Kurve 32 im Diagramm 30 der Figur 3 veranschaulicht wird. Bei diesem Verlauf ist die Porosität beginnend von der Unterseite des Beschichtungsmaterials bis zu einer Dicke d₃, die geringer ist als die zuvor beschriebene Dicke d₁, minimal bzw. gleich Null und nimmt dann bis zur Oberseite d der Beschichtung nichtlinear zu. Abweichend hiervon kann die Kurve 32 selbstverständlich im Bereich nahe der Beschichtungsoberfläche auch in einen linearen Verlauf übergehen. In bestimmten Fällen, beispielsweise bei der Verwendung sehr harter Materialien kann sich die Porosität der Beschichtung wie durch die Kurve 33 in Figur 3 veranschaulicht auch bis oder bis nahe zur Unterseite der Beschichtung 12 an der Grenzfläche zum Grundkörper 11 fortsetzen.

Durch die beschriebene Variation der Materialporosität über die Dicke der Beschichtung 12 kann die Verscheißrate der Beschichtungsoberfläche in Abhängigkeit von deren Restdicke eingestellt werden. Eine Variation der Materialzusammensetzung der Schicht über Ihre Tiefe ist hierzu nicht notwendig. Zur Herstellung solcher Beschichtungen wird vorzugsweise ein handelsübliches Hartmetallpulver mit ca. 8-10% Cobalt und Wolframmonocarbid als Hartstoff verwendet.

Gemäß einer weiteren Ausführungsform variiert zusätzlich zur Porosität auch die Materialzusammensetzung über die Dicke der Beschichtung. Hierdurch ist es möglich, die Verschleißrate an der originären Oberfläche der Beschichtung 12 weiter zu erhöhen und die Einlaufphase zusätzlich zu verkürzen, während die tieferen Schichten der Beschichtung in Bezug auf eine möglichst lange Standzeit der Rakelklinge optimiert werden können. Beispielsweise kann der Bereich der Beschichtung nahe deren Oberseite Materialien mit einer geringeren Härte aufweisen, als die Materialien, die im Bereich deren Unterseite der Beschichtung dominieren.

Beispielsweise kann der oberseitennahe Bereich der Beschichtung 12 einen hohen Anteil an Metalloxiden oder -nitriden wie z.B. Aluminiumoxid oder Titannitrid, aufweisen, während die Schichten nahe des Grundkörpers 11 einen hohen Anteil an metallartigen Carbiden wie z.B. Wolframcarbid, Borcarbid, Chromcarbid, Titancarbid, oder dergleichen aufweisen.

Im Diagramm 40 der Figur 4 ist das Verschleißverhalten 41 einer nicht porösen bzw. gering porösen Beschichtung dem Verschleißverhalten 42 einer wie oben beschriebenen porösen Beschichtung gegenübergestellt. Kurve 41 wie 42 geben die jeweiligen Verschleißvorgänge nur qualitativ wieder und stellen keine messtechnisch oder theoretisch erfassten Verschleißkurven dar. Beschichtung 12 und Grundkörper 11 sind den beiden Kurven zum besseren Verständnis hinterlegt.

Die poröse Oberseite der Beschichtung 12 wird schneller abgetragen als eine geringporöse bzw. porenfreie Beschichtungsoberseite. Entsprechend fällt die Kurve 42 zu Beginn steiler ab als Kurve 41. Mit abnehmender Porosität in den tieferen Schichten der Beschichtung 12 nimmt deren Verschleißrate ab und nähert sich schließlich am Übergang zu den porenfreien tiefen Schichten der einer porenfreien Beschichtung.

Die Erfindung ermöglicht einen anfänglichen hohen Verschleiß der mit der Papieroberfläche bzw. dem Strich in Kontakt stehenden Oberfläche einer Rakelklinge, so dass die Rakelklinge in kurzen Zeiten auf die Geometrie der an ihr entlang geführten Papierbahn eingeschliffen werden kann. Durch die Abnahme der Porosität der Beschichtung hin zu deren Unterseite, nimmt auch die Verschleißrate in der Beschichtung ab, wodurch das im Einlaufprozess erhaltene Oberflächenprofil erhalten und formgetreu an den porenarmen oder porenfreien Teil der Beschichtung überführt wird, der auf eine möglichst geringe Verschleißrate und damit hohe Standzeit der Rakelklinge ausgebildet ist.

## Patentansprüche

1. Rakelklinge zur Oberflächenbehandlung von Faservliesbahnen, mit einem Grundkörper (11) und einer an der Oberfläche des Grundkörpers (11) angeordneten Beschichtung (12), wobei die Beschichtung zumindest den Teil der Oberfläche des Grundkörpers (11) bedeckt, an dem die Rakelklinge (10) zum Kontakt mit der Faservliesbahn vorgesehen ist, und wobei die Porosität der Beschichtung (12) an der ersten, an den Grundkörper (11) angrenzenden Oberfläche kleiner ist, als an der dieser gegenüber angeordneten Oberfläche.

2. Rakelklinge nach Anspruch 1, worin die Porosität der Beschichtung (12) von der ersten, an den Grundkörper (11) angrenzenden Oberfläche zu der dieser gegenüber angeordneten Oberfläche hin zunimmt.

3. Rakelklinge nach Anspruch 1 oder 2, worin die Beschichtung (12) eine erste Schicht umfasst, die an den Grundkörper angrenzt und im wesentlichen keine Poren aufweist, und eine zweite Schicht, die auf der ersten Schicht angeordnet ist und eine vorgegebene Porosität aufweist.

4. Rakelklinge nach Anspruch 3, worin die Beschichtung (12) eine oder mehrere weitere Schichten umfasst, die auf der dem Grundkörper (11) abgewandten Seite der zweiten Schicht angeordnet sind, wobei die Porosität einer weiteren Schicht höher ist als die Porosität einer jeden zwischen der weiteren Schicht und der ersten Schicht angeordneten Schicht der Beschichtung (12).

5. Rakelklinge nach Anspruch 4, worin die erste Schicht mehrere Lagen umfasst.

6. Rakelklinge nach einem der Ansprüche 3 bis 5, worin die Dicke der ersten Schicht wenigstens der Hälfte der Dicke der Beschichtung (12) entspricht.

7. Rakelklinge nach einem der vorangehenden Ansprüche, worin sich die Materialzusammensetzung der zweiten Schicht oder einer weiteren Schicht von der der ersten Schicht unterscheidet.

8. Rakelklinge nach Anspruch 7, worin die erste Schicht aus einem ersten Material gebildet ist und die zweite und/oder eine weitere Schicht aus einem zweiten Material oder einer Mischung von erstem und zweitem Material gebildet ist.

9. Rakelklinge nach einem der vorhergehenden Ansprüche, worin die erste Schicht ein metallartiges Carbid enthält.

10. Rakelklinge nach Anspruch 8 oder 9, worin das zweite Material ein Metalloxid enthält.

## Claims

1. Doctor blade for the surface treatment of fibrous nonwoven webs, having a base (11) and a coating (12) arranged on the surface of the base (11), wherein the coating hides at least that part of the surface of the base (11) on which the doctor blade (10) is provided to make contact with the fibrous nonwoven web, and wherein the porosity of the coating (12) is lower on the first surface, adjoining the base (11), than on the surface arranged opposite the said first surface.

2. Doctor blade according to Claim 1, wherein the porosity of the coating (12) increases from the first surface, adjoining the base (11), to the surface arranged opposite the said first surface.

3. Doctor blade according to Claim 1 or 2, wherein the coating (12) has a first layer, which adjoins the base and has substantially no pores, and a second layer, which is arranged on the first layer and which has a predefined porosity.

4. Doctor blade according to Claim 3, wherein the coating (12) comprises one or more further layers, which are arranged on the side of the second layer that faces away from the base (11), wherein the porosity of a further layer is higher than the porosity of each layer of the coating (12) that is arranged between the further layer and the first layer.

5. Doctor blade according to Claim 4, wherein the first layer comprises a plurality of coats.

6. Doctor blade according to one of Claims 3 to 5, wherein the thickness of the first layer corresponds to at least half of the thickness of the coating (12).

7. Doctor blade according to one of the preceding claims, wherein the material composition of the second layer or of a further layer differs from that of the first layer.

8. Doctor blade according to Claim 7, wherein the first layer is formed from a first material and the second and/or a further layer is formed from a second material or a mixture of the first and second materials.

9. Doctor blade according to one of the preceding claims, wherein the first layer contains a metallic carbide.

10. Doctor blade according to Claim 8 or 9, wherein the second material contains a metal oxide.

## Revendications

1. Lame de raclage pour le traitement de surface de bandes fibreuses non tissées, comprenant un corps de base (11) et un revêtement (12) disposé à la surface du corps de base (11), le revêtement couvrant au moins la partie de la surface du corps de base (11) sur laquelle la lame de raclage (10) doit venir en contact avec la bande fibreuse non tissée, la porosité du revêtement (12) au niveau de la première surface adjacente au corps de base (11) étant inférieure à la porosité au niveau de la surface disposée à l'opposé de celle-ci.

2. Lame de raclage selon la revendication 1, dans laquelle la porosité du revêtement (12) augmente depuis la première surface adjacente au corps de base (11) jusqu'à la surface disposée à l'opposé de celle-ci.

3. Lame de raclage selon la revendication 1 ou 2, dans laquelle le revêtement (12) comprend une première couche qui est adjacente au corps de base et qui ne présente essentiellement aucun pore, et une deuxième couche qui est disposée sur la première couche et qui présente une porosité prédéfinie.

4. Lame de raclage selon la revendication 3, dans laquelle le revêtement (12) comprend une ou plusieurs autres couches qui sont disposées sur le côté de la deuxième couche opposé au corps de base (11), la porosité d'une couche supplémentaire étant supérieure à la porosité de chaque couche du revêtement (12) disposée entre la couche supplémentaire et la première couche.

5. Lame de raclage selon la revendication 4, dans laquelle la première couche comprend plusieurs strates.

6. Lame de raclage selon l'une quelconque des revendications 3 à 5, dans laquelle l'épaisseur de la première couche correspond au moins à la moitié de l'épaisseur du revêtement (12).

7. Lame de raclage selon l'une quelconque des revendications précédentes, dans laquelle la composition de matière de la deuxième couche ou d'une couche supplémentaire est différente de celle de la première couche.

8. Lame de raclage selon la revendication 7, dans laquelle la première couche est formée d'une première matière et la deuxième et/ou une couche supplémentaire est/sont formée(s) d'une deuxième matière ou d'un mélange de la première et de la deuxième matière.

9. Lame de raclage selon l'une quelconque des revendications précédentes, dans laquelle la première couche contient un carbure de type métallique.

10. Lame de raclage selon la revendication 8 ou 9, dans laquelle la deuxième matière contient un oxyde métallique.
